Europäisches Patentamt

European Patent Office

Office européen des brevets

(19)

(11) Veröffentlichungsnummer: **0 358 795 B1**

# (12) EUROPÄISCHE PATENTSCHRIFT

(45) Veröffentlichungstag der Patentschrift: **09.06.93**

(21) Anmeldenummer: **88115022.1**

(22) Anmeldetag: **14.09.88**

(51) Int. Cl.⁵: **H03H 3/10**

(54) **Elektroakustisches Bauelement aus piezokeramischem Material und Verfahren zum Frequenz- bzw. Laufzeitabgleich des Bauelementes.**

(43) Veröffentlichungstag der Anmeldung:
**21.03.90 Patentblatt 90/12**

(45) Bekanntmachung des Hinweises auf die
Patenterteilung:
**09.06.93 Patentblatt 93/23**

(84) Benannte Vertragsstaaten:
**DE FR GB**

(56) Entgegenhaltungen:
**EP-A- 0 141 487**
**DE-A- 2 317 761**
**US-A- 3 710 465**
**US-A- 3 750 056**

(73) Patentinhaber: **SIEMENS AKTIENGESELL-**
**SCHAFT**
**Wittelsbacherplatz 2**
**W-8000 München 2(DE)**

(72) Erfinder: **Prestele, Karl, Dipl.Phys.**
**Bismarckstrasse 21d**
**W-8520 Erlangen(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein elektroakustisches Bauelement mit einem Substrat aus polarisierten piezokeramischem Material, auf dem in einem Abstand voneinander zwei elektroakustische Wandler angeordnet sind. Zu den elektroakustischen Bauelementen gehören z.B. elektrische Filter, Oszillatoren, Resonatoren und Verzögerungselemente.

Die Erfindung betrifft ebenfalls ein Verfahren zum Frequenz- bzw. Laufzeitabgleich des Bauelements.

Bei elektroakustischen Bauelementen aus piezokeramischem Material werden Toleranzen des Frequenzverhaltens bzw. der Verzögerungszeit im wesentlichen durch die Toleranz der Schallgeschwindigkeit bestimmt. Mit hochwertigen Blei-Zirkonat-Titanat-Keramiken (PZT-Keramiken) erreicht man beim heutigen Stand günstigen falls eine Schallgeschwindigkeitstoleranz von ± 0,5 %. Engere Toleranzen können durch Abgleich der Bauelemente erreicht werden.

Ein elektroakustisches Bauelement der eingangs genannten Art und ein Verfahren zum Abgleich oder Ändern der Laufzeit zwischen einem Eingangs- und einem Ausgangswandler auf einem piezoelektrischen Substrat aus polarisierter Keramik ist in der US-PS 3 710 465 beschrieben. Dort wird durch Anlegen eines elektrischen Feldes zwischen den beiden Wandlern die Remanenzpolarisation des polarisierten Materials geändert. Die geänderte Remanenzpolarisation hat einen geänderten Elastizitätsmodul zur Folge und somit eine geänderte Schallgeschwindigkeit auf der Strecke zwischen den beiden Wandlern. Jedoch müssen dazu auf dem Bauelement großflächige Elektroden vorhanden sein. Im Bereich der Koerzitivfeldstärke läßt sich wegen der großen Steilheit der Hystereseschleife die gewünschte neue Polarisation nur ungenau oder nach mehrmaligen Versuchen einstellen.

Ein Verfahren zum Abgleich piezoelektrischer monolithischer Keramikfilter ist in der DD-PS 236 836 angegeben. Das genaue Einstellen wichtiger Filterparameter erfolgt dort durch Abtrag von Elektrodenmaterial mittels Laserstrahlung. Dabei wird die Abhängigkeit der wesentlichen elektrischen Filterkenngrößen von den Abmessungen der Metallelektrodenkonfiguration des Filterplättchens ausgenutzt. Dadurch sind optimale und exakt reproduzierbare Filtereigenschaften in der Massenproduktion erzielbar. Zum Abtragen des metallischen Elektrodenmaterials sind jedoch hohe Temperaturen erforderlich, daher besteht bei piezokeramischen Substraten die Gefahr der Rißbildung und der Depolarisierung.

Ein anderes Verfahren zum Abgleichen der Frequenz-Amplituden- Charakteristik von Interdigitalwandlern ist in der DE-OS 23 17 761 beschrieben. Dort wird die wirksame Fingerlänge der Wandler nicht durch Ändern des Elektrodenabmessungen, sondern durch Depolarisierung des darunterliegenden piezoelektrischen Keramiksubstrats beeinflußt. Die Depolarisation wird durch lokale Erwärmung des Keramiksubstrats über die Curietemperatur mit Hilfe von fokussiertem Laserlicht erreicht.

Ohne zusätzliches Abgleichen werden bei höheren Toleranzanforderungen auch kristalline piezoelektrische Substrate, wie z.B. Quarz oder Lithiumniobat, verwendet. Wegen der im Vergleich zur Piezokeramik wesentlich schlechteren elektromechanischen Kopplung bei diesen Materialien müssen geringere Bandbreite und höhere Einfügedämpfung in Kauf genommen werden.

Der Erfindung liegt die Aufgabe zugrunde, ein elektroakustisches Bauelement mit kleiner Einfügedämpfung und mit engtoleriertem Frequenzverhalten bzw. Verzögerungszeiten bereitzustellen. Dazu soll ein Verfahren zum genauen Abgleich angegeben werden.

Die Aufgabe wird dadurch gelöst, daß das Substrat zwischen den beiden Wandlern eine die Laufzeit oder das Frequenzverhalten beeinflussende depolarisierte Zone aufweist.

Erfindungsgemäß zeichnet sich das Verfahren zur Herstellung des elektroakustischen Bauelementes dadurch aus, daß das piezokeramische Material zum Abgleich der Laufzeit oder des Frequenzverhaltens örtlich über die Curietemperatur erhitzt wird.

Der Erfindung liegt die Erkenntnis zugrunde, daß die Schallausbreitung in piezokeramischen Substraten vom Polarisierungsgrad und von der Schallausbreitungsrichtung relativ zur Polarisierungsrichtung abhängt. Typischerweise ist die Schallgeschwindigkeit in einer bis zur Sättigung polarisierten PZT-Keramik etwa 10 bis 20 % höher als im unpolarisierten Zustand.

Dieser Effekt wird zur Herstellung des engtolerierten Bauelements benutzt, indem durch lokale thermische Depolarisation die Verzögerungszeit bzw. das Frequenzverhalten in kleinen definierten Schritten auf einen vorgegebenen Wert einstellbar ist. Die Depolarisierung wird dadurch erreicht, daß das piezokeramische Material lokal auf eine Temperatur knapp über der Curietemperatur erwärmt wird.

Da die Curietemperatur je nach Keramik zwischen 200°C und 400°C liegt, ist durch die relativ "sanfte" Erwärmung eine Schädigung der Keramik, wie z.B. Rißbildung, insbesondere auch bei dünnen Keramikplättchen, ausgeschlossen.

Eine vorteilhafte Ausführungsform zeichnet sich dadurch aus, daß die depolarisierte Zone sich säulenförmig über die gesamte Breite des Bauelements erstreckt. Dadurch wird erreicht, daß die depolarisierte Zone den gesamten Schallweg gleichmäßig beeinflußt.

Bei einer weiteren vorteilhaften Ausgestaltung sind die Grenzflächen zwischen der depolarisierten Zone und dem piezokeramischen Material schräg zur Schallausbreitungsfront ausgerichtet. Dadurch werden Störsignale unterdrückt, die durch Reflexion am Übergang von polarisierten zu depolarisierten Substratbereichen wegen der unterschiedlichen Wellenwiderstände auftreten.

Bei dem Verfahren zur Herstellung des elektroakustischen Bauelementes ist es besonders vorteilhaft, die Depolarisierung berührungslos mit einem Laserstrahl durchzuführen, da hierbei die Wellenlänge und die Leistung sowie der Spotdurchmesser des Laserstrahls genau so einstellbar sind, daß die Curietemperatur im Material nicht wesentlich überschritten wird. Zudem ist so eine unerwünschte Verbreiterung der depolarisierten Zone durch Wärmeleitung nahezu ausgeschlossen.

Weitere vorteilhafte Ausgestaltungen ergeben sich aus den Unteransprüchen und aus der Beschreibung eines Ausführungsbeispiels.

Die FIG zeigt in perspektivischer Ansicht eine Verzögerungsleitung aus piezokeramischen Material.

Eine Verzögerungsleitung 2 ist aus einem piezokeramischen Material, wie z.B. Blei-Zirkonat-Titanat (PZT-Keramik) aufgebaut. Auf einem monolithischen Substrat 4 sind im Abstand L zwei elektroakustische Wandler 6 und 8 angeordnet. Die Wandler 6 und 8 werden jeweils durch eine interdigitale Elektrodenstruktur aus den Elektroden 10 und 12 zusammen mit dem darunterliegenden Bereich des piezokeramischen Substrats 4 gebildet.

Der Wandler 6 z.B. erzeugt nach Anlegen eines elektrischen Signals an seinen Elektroden 10 und 12 eine akustische Welle im Substrat 4. Der Wellentyp hängt von der Richtung des elektrischen Feldes zur Polarisierungsrichtung des Substrates 4 ab. Das Substrat ist hier so polarisiert, daß eine akustische Plattenscherwelle entsteht. Die akustische Welle läuft nun über den Abstand L im Substrat 4 vom Wandler 6 zum Wandler 8. Dieser Bereich des Substrates 4 bildet eine Laufzeit- oder Verzögerungsstrecke 14. Die ebenfalls vom Wandler 6 abgestrahlte Welle in entgegengesetzter Richtung wird durch einen Absorber oder einen akustischen Sumpf 16 absorbiert. Der Wandler 8 wandelt die auftreffende akustische Welle wieder in ein elektrisches Signal um, das zum Signal am Wandler 6 um die Zeit t verzögert ist, entsprechend der Laufzeit der akustischen Welle über den Abstand L. Ein hinter dem Wandler 8 angeordneter weiterer Absorber oder Sumpf 16 dämpft die weiterlaufende akustische Welle. Durch die beiden Sümpfe 16 werden Reflexionen an den Kanten des Substrates 4 (Kantenechos) unterdrückt.

Da die Ausbreitungsgeschwindigkeit von akustischen Wellen in piezokeramischem Material wesentlich geringer ist als die Ausbreitungsgeschwindigkeit von elektromagnetischen Wellen, wird durch den Abstand L der beiden Wandler 6 und 8 eine entsprechend längere Verzögerung eines elektrischen Signals erreicht.

Parallel zur Schallausbreitungsfront ist auf der Verzögerungsstrecke 14 eine säulenförmige depolarisierte Zone 18 geschaffen. Die Zone erstreckt sich über die gesamte Breite 20 des Substrates 4 oder Bauteiles. Dabei ist darauf zu achten, daß bei der örtlichen Erhitzung über die Curietemperatur die Zone 18 gleichmäßig über die Substrat- oder Plattendicke d erwärmt wird. Bei dickeren Platten kommt auch eine gleichzeitige Erwärmung von beiden Seiten in Frage. Bei Oberflächenwellenbauelementen gilt analog, daß die Breite der depolarisierten Zone größer oder gleich der Eindringtiefe der akustischen Oberflächenwellen ist.

Die Verzögerungszeit t auf der Verzögerungsstrecke 14 wird durch die säulenförmige depolarisierte Zone 18 um den Betrag

$$\Delta t = b \cdot \frac{v_p - v_d}{v_p \cdot v_d}$$

verlängert, wobei $v_p$ die Schallgeschwindigkeit im polarisierten Substrat 4 und $v_d$ die Schallgeschwindigkeit in der depolarisierten Zone 18 ist.

Da die Laufzeit t durch die Depolarisierung der Zone 18 nur verlängert werden kann, muß bei der Dimensionierung der Laufzeitstrecke 14 der erforderliche Korrekturspielraum durch eine entsprechende Verkürzung von L bereitgestellt werden. Die genaue Einstellung der geforderten Verzögerungszeit t erfolgt durch Aneinanderreihen von depolarisierten Zonen 18, wie es in der FIG gestrichelt angedeutet ist.

Die nach Abgleich noch zulässige Laufzeittoleranz hängt in erster Linie von der Breite b einer einzigen depolarisierten Zone 18 ab.

Soll diese z.B. $\pm \delta t$ betragen, so erhält man daraus theoretisch die Breite b der depolarisierten Zone 18

$$b = 2 \delta t \frac{v_p \cdot v_d}{v_p - v_d} \cdot$$

Der Wellenwiderstand der depolarisierten Zone 18 unterscheidet sich vom Wellenwiderstand des polarisierten piezokeramischen Substrates. Dadurch wird ein Teil der Schallwelle reflektiert. Um durch Mehrfachreflexionen bedingte Störsignale zu unterdrücken, können die Grenzflächen zwischen der depolarisierten Zone 18 und dem polarisierten piezokeramischen Material und somit die depolarisierte Zone selbst schräg zur Schallausbreitungsfront ausgerichtet werden.

Besonders vorteilhaft erfolgt die Depolarisierung der Zone 18 berührungslos mit einem Laserstrahl im Scanverfahren. Dabei läßt sich in einfacher Weise die Wellenlänge und die Leistung sowie der Vorschub des Laserstrahls so anpassen, daß gerade die Curietemperatur bzw. die zur vollständigen Depolarisierung erforderliche Temperatur erreicht wird. Eine zu starke Erwärmung wird dadurch vermieden, so daß keine unerwünschte Verbreiterung der depolarisierten Zone 18 durch Wärmeleitung oder Rißbildung im Substrat 4 auftritt.

Da nur relativ kleine Leistungen zur Depolarisierung benötigt werden, kommen auch konventionelle Punktlichtquellen mit geeigneter Fokussierung in Frage. Auch hier erfolgt die Erwärmung berührungslos.

Alternativ zur berührungslosen Erwärmung kann auch mit einem beheizten Element, z.B. einem heizbaren Draht, durch Kontakt das Substrat 4 örtlich erhitzt und damit depolarisiert werden.

Zur Einstellung der gewünschten Verzögerungszeit t kann z.B. nach jeder neu depolarisierten Zone 18 die Verzögerungszeit t gemessen und in Abhängigkeit vom Ergebnis entschieden werden, ob weitere depolarisierte Zonen 18 aufgebracht werden sollen oder ob die bestmögliche Annäherung an den Sollwert erreicht ist.

Ebenso ist es möglich, aus einer anfangs gemessenen Sollwertabweichung des vollständig polarisierten Substrats 4 die Anzahl der erforderlichen depolarisierten Zonen 18 zu berechnen und dann in einem Zuge ohne weitere Messungen zu depolarisieren.

Durch die Anordnung von depolarisierten Zonen 18 in der Laufzeitstrecke 14 von elektroakustischen Bauelementen aus piezokeramischem Material kann das Frequenzverhalten bzw. die Verzögerungszeit dieser Bauelemente sehr eng toleriert werden. Somit können hochgenaue Bauelemente mit großer Bandbreite und geringer Einfügedämpfung auf einfache Art hergestellt werden.

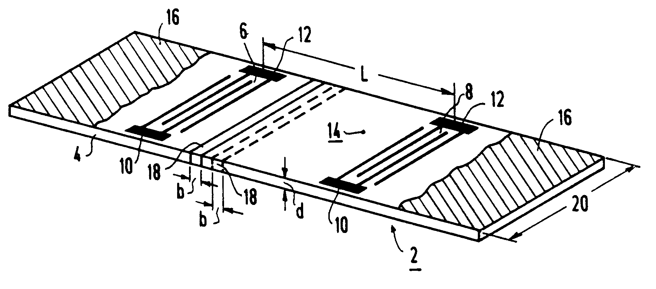

## Patentansprüche

1. Elektroakustisches Bauelement mit einem Substrat (4) aus polarisiertem piezokeramischem Material, auf dem in einem Abstand (L) voneinander zwei elektroakustische Wandler (6,8) angeordnet sind, **dadurch gekennzeichnet,** daß Substrat (4) zwischen den beiden Wandlern (6,8) eine die Laufzeit oder das Frequenzverhalten beeinflussende depolarisierte Zone (18) aufweist.

2. Elektroakustisches Bauelement nach Anspruch 1, **dadurch gekennzeichnet,** daß die depolarisierte Zone (18) sich säulenförmig über die gesamte Breite (20) des Substrats (4) erstreckt.

3. Elektroakustisches Bauelement nach Anspruch 1 oder 2, **dadurch gekennzeichnet,** daß die Grenzflächen zwischen der depolarisierten Zone (18) und dem polarisierten piezokeramischen Material schräg zur Schallausbreitungsfront ausgerichtet sind.

4. Verfahren zur Herstellung eines elektroakustischen Bauelementes nach Anspruch 1, **dadurch gekennzeichnet,** daß das piezokeramische Material zum Abgleich der Laufzeit oder des Frequenzverhaltens örtlich über die Curietemperatur erhitzt wird.

5. Verfahren nach Anspruch 4, **dadurch gekennzeichnet,** daß die örtliche Erhitzung berührungslos mit Laserlicht erfolgt.

6. Verfahren nach Anspruch 4, **dadurch gekennzeichnet,** daß die örtliche Erhitzung berührungslos mit einer fokussierten Punktlichtquelle erfolgt.

7. Verfahren nach Anspruch 4, **dadurch gekennzeichnet,** daß die örtliche Erhitzung durch Kontakt mit einem erhitzten Element erfolgt.

## Claims

1. Electro-acoustic component having a substrate (4) of polarised piezo-ceramic material on which two electro-acoustic transducers (6, 8) are arranged at a distance (L) from each other, characterised in that substrate (4) between the two transducers (6, 8) has a depolarised zone (18) influencing the transit time or the frequency behaviour.

2. Electro-acoustic component according to claim 1, characterised in that the depolarised zone (18) extends like a column over the entire width (20) of the substrate (4).

3. Electro-acoustic component according to claim 1 or 2, characterised in that the boundary surfaces between the depolarised zone (18) and the polarised piezo-ceramic material are aligned with an inclination to the sound propagation front.

4. Process for the production of an electro-acoustic component according to claim 1, characterised in that the piezo-ceramic material is locally heated above the Curie temperature to adjust the transit time or the frequency behaviour.

5. Process according to claim 4, characterised in that the local heating is effected by laser light without contact.

6. Process according to claim 4, characterised in that the local heating is effected by a focussed point light source without contact.

7. Process according to claim 4, characterised in that the local heating is effected by contact with a heating element.

**Revendications**

1. Composant électro-acoustique pourvu d'un substrat (4) réalisé en un matériau piézocéramique polarisé et sur lequel deux transducteurs électro-acoustiques (6,8) sont disposés à une distance (L) l'un de l'autre, caractérisé par le fait que le substrat (4) possède, entre les deux transducteurs (6,8), une zone dépolarisée (18), qui influe sur le temps de propagation ou le comportement en fréquence.

2. Composant électro-acoustique suivant la revendication 1, caractérisé par le fait que la zone dépolarisée (18) s'étend sous la forme d'une colonne, sur toute la largeur (20) du substrat (4).

3. Composant électro-acoustique suivant la revendication 1 ou 2, caractérisé par le fait que les surfaces limites entre la zone dépolarisée (18) et le matériau céramique polarisé sont alignées obliquement par rapport au front de propagation du son.

4. Procédé pour fabriquer un composant électro-acoustique suivant la revendication 1, caractérisé par le fait qu'on chauffe localement le matériau piézocéramique audessus de la température de Curie pour réaliser une compensation du temps de propagation ou du comportement en fréquence.

5. Procédé suivant la revendication 4, caractérisé par le fait que le chauffage localisé s'effectue sans contact avec une lumière laser.

6. Procédé suivant la revendication 4, caractérisé par le fait que le chauffage localisé s'effectue sans contact avec une source de lumière ponctuelle focalisée.

7. Procédé suivant la revendication 4, caractérisé par le fait que le chauffage localisé s'effectue par contact avec un élément chauffé.